# EUROPÄISCHE PATENTSCHRIFT

(11) **EP 3 474 452 B1**
(45) Veröffentlichungstag und Bekanntmachung des Hinweises auf die Patenterteilung: **17.11.2021**
(21) Anmeldenummer: 18186279.8
(22) Anmeldetag: 30.07.2018
(51) Int. Cl.: H03K 17/955

(54) **VERFAHREN ZUM AUSWERTEN EINES KAPAZITÄTSWERTS EINER KAPAZITIVEN SENSORELEKTRODE**
METHOD FOR EVALUATING A CAPACITY VALUE OF A CAPACITIVE SENSOR ELECTRODE
PROCÉDÉ D'ÉVALUATION D'UNE VALEUR DE CAPACITÉ D'UNE ÉLECTRODE DE DÉTECTION CAPACITIVE

(30) Priorität: 18.10.2017 DE 102017124309
(43) Veröffentlichungstag der Anmeldung: 24.04.2019
(73) Patentinhaber: HUF Hülsbeck & Fürst GmbH & Co. KG, 42551 Velbert (DE)
(72) Erfinder: SIEG, Berthold, 46240 Bottrop (DE)
(74) Vertreter: Zenz Patentanwälte Partnerschaft mbB

(56) Entgegenhaltungen:
- WO-A1-2016/061429
- DE-A1-102012 224 037
- DE-U1- 29 721 213

## Beschreibung

Die Erfindung betrifft ein Verfahren zum Auswerten eines Kapazitätswerts einer kapazitiven Sensorelektrode.

Die Verwendung von kapazitiven Sensorelektroden ist aus der Praxis für eine Vielzahl von Anwendungen bekannt.

Ein Beispiel für die Nutzung von kapazitiven Sensorelektroden sind kapazitive Näherungsschalter, die in Fahrzeugen eingerichtet sind, um beispielsweise eine Anwesenheit einer Person zu detektieren. Die Funktionalität eines solchen kapazitiven Näherungsschalters beruht darauf, dass die Kapazität einer kapazitiven Sensorelektrode des Näherungsschalters einen bestimmten Wert erreicht oder überschreitet oder aber eine vorgegebene absolute oder relative Änderung erfährt.

Zur Auswertung der Kapazität zu einem bestimmten Zeitpunkt beziehungsweise während eines bestimmten Zeitraums wird die kapazitive Sensorelektrode mit einem vorgegebenen Potenzial gekoppelt. Die Sensorelektrode bildet mit einer Referenzelektrode eine Kapazität. Als Referenzelektrode kann bei dem Beispiel des in einem Fahrzeug vorhandenen Näherungsschalters eine Fahrzeugmasse oder eine Masse des unter dem Fahrzeug befindlichen Bodens dienen. Wenn ein Körperteil eines Benutzers, beispielsweise eine Hand oder ein Fuß, in den sensitiven Bereich der Sensorelektrode eintritt, verändern sich die elektrostatischen Eigenschaften des Gesamtsystems. Im Rahmen einer Ersatzbetrachtung kann dieser Effekt als eine Änderung des die Sensorelektrode umhüllenden Dielektrikums aufgefasst werden.

Um aus dem Kapazitätswert der Sensorelektrode oder aus der Änderung des Kapazitätswerts der Sensorelektrode eine Information, beispielsweise über das Vorhandensein einer Hand oder eines Fußes, ableiten zu können, ist die Auswertung des Kapazitätswerts erforderlich.

Eine Schaltungsanordnung für ein Sensorelement ist der DE 297 21 213 U1 zu entnehmen.

Die Auswertung des Kapazitätswerts kann auf unterschiedliche Weise erfolgen. Beispielsweise kann vorgesehen sein, dass ein wiederholtes Aufladen der Sensorelektrode auf ein Referenzpotenzial einer Spannungsquelle und Entladen der Sensorelektrode in eine Vergleichskapazität vorgenommen wird und im Anschluss an das wiederholte Auf- und Entladen eine Auswertung der auf der Vergleichskapazität akkumulierten Ladung erfolgt. Ein Beispiel für eine Umsetzung dieses Prinzips ist der DE 196 81 725 B4 zu entnehmen.

Grundsätzlich wird für die Auswertung des Kapazitätswerts das Prinzip genutzt, die Sensorelektrode periodisch zu laden und im Anschluss an das periodische Laden einen kapazitätsabhängigen Parameter, entweder des Ladevorgangs oder des, in den meisten Fällen ebenfalls periodisch durchgeführten, Entladevorgangs auszuwerten.

Bei dem auszuwertenden Parameter kann es sich beispielsweise um eine Spannung handeln, die über einem Ladung ansammelnden Kondensator gemessen wird, wie es bei dem Beispiel der oben genannten Druckschrift der Fall ist.

Eine andere Möglichkeit für den auszuwertenden Parameter kann eine bestimmte Anzahl von Lade- und Entladezyklen bis zum Überschreiten einer Schaltschwelle an einem Kompensationskondensator sein. Ein Beispiel für eine derartige Vorgehensweise ist der DE 10 2013 112 910 A1 zu entnehmen. Bei dem in dieser Druckschrift beschriebenen Verfahren wird während einer ersten Phase die kapazitive Sensorelektrode über eine erste Schalteinrichtung mit einer Ladespannung gekoppelt, um die Sensorelektrode aufzuladen. Gleichzeitig wird eine Kompensationskapazität mittels einer weiteren, zweiten Schalteinrichtung zwischen eine Referenzspannung und Masse eingekoppelt, wodurch die Kompensationskapazität ebenfalls mit einer Ladung belegt wird. Daran anschließend wird ein Ladungsausgleich zwischen Sensorelektrode und Kompensationskapazität vorgenommen. Die Ermittlung der Elektrodenkapazität erfolgt auf Grundlage einer Auswertung der auf der Kompensationskapazität akkumulierten Ladung.

Insgesamt ist also festzuhalten, dass aus dem Stand der Technik und aus der Praxis bekannte Verfahren zur Auswertung des Kapazitätswerts einer kapazitiven Sensorelektrode voraussetzen, dass die Sensorelektrode zyklisch geladen wird. Je nach konkreter Ausführungsform kann vorgesehen sein, die Sensorelektrode in mehreren Zyklen schrittweise zu laden, oder die Sensorelektrode in jeweils jedem Zyklus aus mehreren Zyklen sowohl - teilweise oder vollständig - zu laden und - teilweise oder vollständig - zu entladen.

Um ein zuverlässiges Auswerten der Kapazität der Sensorelektrode in ausreichend kurzer Zeit zu gewährleisten, erfolgt das zyklische Laden und gegebenenfalls auch Entladen der Sensorelektrode in der Regel mit vergleichsweise hohen Frequenzen. Oftmals werden Frequenzen im Bereich von einigen 10 kHz bis zu mehreren 100 kHz vorgesehen.

Aufgrund des hochfrequenten Aufladens der Sensorelektrode ergibt sich - tendenziell bei höherer Frequenz in deutlicherer Ausprägung - das Problem, dass infolge des hochfrequenten zyklischen Ladens und gegebenenfalls Entladens unerwünschte elektromagnetische Wechselfelder gebildet werden. Je nach Größe und Form der Sensorelektrode, schalttechnischer Umsetzung der Ansteuerung der Sensorelektrode und gewählter Frequenz wirkt die Sensorelektrode in entsprechendem Maße als Antenne und strahlt elektromagnetische Strahlung ab. Dieser Effekt kann vor allem vor dem Hintergrund problematisch sein, dass elektromagnetische Wellen abstrahlende Produkte regulatorischen Beschränkungen unterliegen. Beispielsweise bestehen in der Bundesrepublik Deutschland Beschränkungen auf der Grundlage des Bundesimmissionsschutzgesetzes, aus denen verbindliche Grenzwerte für elektromagnetische Abstrahlungen abgeleitet werden. Die entsprechenden Grenzwerte sind frequenzabhängig und vergleichsweise rigide. Die zur Auswertung von Sensorelektroden, wie eingangs erläutert, typischerweise vergleichsweise hohen verwendeten Frequenzen einerseits und die strengen regulatorischen Anforderungen andererseits stellen hohe Anforderungen an die Auslegung und an den Betrieb kapazitiver Sensorelektroden.

Vor dem Hintergrund der vorgenannten Überlegungen ist es Aufgabe der Erfindung, die Auswertung eines Kapazitätswerts einer kapazitiven Sensorelektrode sowie die Anordnung einer kapazitiven Sensorelektrode, beispielsweise in einem Kraftfahrzeug, mit verbesserter Flexibilität, beispielsweise hinsichtlich der Formgebung und des Anbringungsorts, zu erlauben.

Die Aufgabe wird mit einem Verfahren mit den Merkmalen des Anspruchs 1 gelöst.

Vorteilhafte Weiterbildungen ergeben sich aus den Unteransprüchen.

Das Verfahren dient dem Zweck, einen Kapazitätswert einer kapazitiven Sensorelektrode auszuwerten. Für das Auswerten der Kapazität wird zumindest ein zyklisches Laden der Sensorelektrode vorgenommen. Das zyklische Laden der Sensorelektrode umfasst dabei, dass die Sensorelektrode einer Anzahl von Kopplungs- und Entkopplungszyklen unterzogen wird. Im Zuge jedes der Kopplungs- und Entkopplungszyklen wird die Sensorelektrode während einer Kopplungszeitdauer t_{K} mit einem Ladeschaltkreis gekoppelt. Während des Koppelns der Sensorelektrode mit dem Ladeschaltkreis wird die Sensorelektrode teilweise oder vollständig mit elektrischer Ladung belegt. Die Menge der von der kapazitiven Elektrode aufgenommenen Ladung ist gemäß dem prinzipiellen Zusammenhang C = Q / U von der Kapazität abhängig, mit C: Kapazität, Q = Ladungsmenge, U = elektrische Spannung. Im Anschluss an die Kopplungszeitdauer t_{K} wird die Sensorelektrode während einer Entkopplungszeitdauer t_{E} von dem Ladeschaltkreis entkoppelt.

Während der Kopplungszeitdauer t_{K} erfolgt wenigstens ein teilweises Laden der Sensorelektrode. Während der Entkopplungszeitdauer t_{E} erfolgt kein Laden der Sensorelektrode. Prinzipiell kann auch vorgesehen sein, dass während der Kopplungszeitdauer t_{K} ein vollständiges Laden der Sensorelektrode erfolgt. Während der Entkopplungszeitdauer t_{E} kann vorgesehen sein, dass nicht nur kein Laden, sondern auch ein teilweises oder vollständiges Entladen der Sensorelektrode erfolgt. Für die konkrete Umsetzung des Ladens der Sensorelektrode in schaltungstechnischer Hinsicht sind vielerlei Implementierungen für den Fachmann umsetzbar. Auch die dahingehende Implementierungsentscheidung, ob während der Entkopplungszeitdauer t_{E} lediglich das Laden unterbrochen wird oder auch ein Entladen der Sensorelektrode vorgesehen ist, beispielsweise durch Ankoppeln der Sensorelektrode an einen Auswerteschaltkreis und/oder durch Umladen von auf der Sensorelektrode vorhandener Ladung auf einen Kompensationskondensator, ist von der jeweils fachmännischen Auswahl des Auswertungsverfahrens sowie dessen konkreter Umsetzung durch den Fachmann abhängig.

Der Begriff des Schaltkreises ist allgemein, dem Verständnis des Fachmanns entsprechend, zu verstehen als elektrisch miteinander verbundene Bauelemente der Elektronik. Der Begriff des Schaltkreises ist damit im Rahmen dieser Anmeldung synonym zu dem Begriff der elektrischen Schaltung verwendet, wobei jede Art der elektrischen Schaltung zur Verwirklichung der Erfindung genutzt werden kann. In speziellen Ausführungen der Erfindung kann der Begriff des Schaltkreises sich auch auf integrierte Schaltkreise beziehen, es sind also Ausführungsformen der Erfindung möglich, in denen einer oder mehrere der Schaltkreise als integrierter Schaltkreis ausgebildet ist beziehungsweise sind.

Unabhängig von der konkreten Implementierung der Auswertung der Kapazität der Sensorelektrode ist wesentliche Voraussetzung für die Durchführung des erfindungsgemäßen Verfahrens, dass ein zyklisches Laden oder ein zyklisches sequentielles Laden der Sensorelektrode erfolgt.

Das erfindungsgemäße Verfahren weist den Schritt auf, dass ein von dem Kapazitätswert der Sensorelektrode abhängiger Parameter ausgewertet wird. Das Auswerten des von dem Kapazitätswert der Sensorelektrode abhängigen Parameters kann dabei in jedem Kopplungs- und Entkopplungszyklus, in mehr als einem aber nicht allen Kopplungs- und Entkopplungszyklen, oder aber erst nach Abschluss aller Kopplungs- und Entkopplungszyklen erfolgen.

Der zur Auswertung des Kapazitätswerts herangezogene Parameter kann beispielsweise ein Spannungsverlauf am Anschluss der Sensorelektrode sein oder ist erfindungsgemäß eine an einem Ladung ansammelnden Kondensator gemessene Spannung oder eine bestimmte Anzahl von Perioden des Ladens und/oder Entladens bis zum Überschreiten einer Schaltschwelle durch eine an der Sensorelektrode gemessene Spannung.

Die genannten Verfahrensschritte des Koppelns der Sensorelektrode mit dem Ladeschaltkreis und des Entkoppelns der Sensorelektrode von dem Ladeschaltkreis wie auch die Ermittlung des Kapazitätswerts oder einer den Kapazitätswert repräsentierenden Vergleichsgröße sind dem Fachmann bekannt, beispielsweise aus den eingangs genannten Druckschriften.

Gegenüber den aus der Praxis bekannten Vorgehensweisen unterscheidet sich das erfindungsgemäße Verfahren dadurch, dass innerhalb eines Auswertungsvorgangs mehrere Kopplungs- und Entkopplungszyklen durchgeführt werden und dass die Zeitdauer der Kopplungs- und Entkopplungszyklen innerhalb des Auswertungsvorgangs verändert wird. Mit anderen Worten ist die Pulsfrequenz der Kopplungs- und Entkopplungszeitdauern während eines Auswertungsvorgangs variabel.

Anders ausgedrückt, sind zumindest eine erste Ladepulsdauer t_{L},₁ und eine zweite Ladepulsdauer t_{L},₂ vorgesehen. Die erste Ladepulsdauer setzt sich summativ aus einer ersten Kopplungszeitdauer t_{K,1} und einer ersten Entkopplungszeitdauer t_{E,1} zusammen. Die zweite Ladepulsdauer t_{L,2} setzt sich summativ aus einer zweiten Kopplungszeitdauer t_{K,2} und einer zweiten Entkopplungszeitdauer t_{E,2} zusammen.

In der hier verwendeten Nomenklatur sind die erste und die zweite Ladepulsdauer die Ladepulsdauern eines ersten Kopplungs- und Entkopplungszyklus und eines zweiten Kopplungs- und Entkopplungszyklus, die unmittelbar aufeinander folgen. Es muss sich jedoch nicht zwangsläufig um die ersten beiden Kopplungs- und Entkopplungszyklen eines Auswertungsvorgangs handeln, sondern es kann sich um zwei an beliebiger Position einer Sequenz von Kopplungs- und Entkopplungszyklen eines Auswertungsvorgangs unmittelbar aufeinander folgende Kopplungs- und Entkopplungszyklen handeln.

Die erste Ladepulsdauer und die zweite Ladepulsdauer unterscheiden sich erfindungsgemäß in ihrer Länge. Die erste Ladepulsdauer weicht von der zweiten Ladepulsdauer um eine erste Pulsdauerabweichung Δt_{L,1} ab. Mathematisch ausgedrückt gilt für die Pulsdauerabweichung Δt_{L,1} = t_{L,2} - t_{L,1}.

Dadurch, dass die erfindungsgemäße Variation der innerhalb eines Auswertungsvorgangs verwendeten Ladepulsdauern umgesetzt wird, wird die Abstrahlungscharakteristik der Sensorelektrode während der Auswertung ihrer Kapazität in vorteilhafter Weise beeinflusst. Durch die Variation der Ladepulsdauern werden die Maximalwerte der frequenzabhängigen Abstrahlungsleistungsdichte verringert zugunsten einer Verbreiterung der Bandbreite des Signalspektrums. Die frequenzabhängigen Abstrahlungs-Peaks verschmieren also und werden in ihrer Höhe geringer. Mit anderen Worten wird eine breitere Verteilung der Abstrahlungsenergiedichte auf Abstrahlungsfrequenzen erreicht. Außerdem wird die Abstrahlung von Oberwellen vermieden oder zumindest in ihrer Ausprägung verringert.

Die Erfindung macht sich also die Erkenntnis zunutze, dass bei kapazitiven Sensorelektroden mit bekannten und üblichen Auswerteverfahren ein Laden der Sensorelektrode zu problematischen Effekten führen kann, wenn es mit zu hoher Ladefrequenz durchgeführt wird. Durch Variationen der Ladefrequenz werden derartige Effekte verringert oder gar vermieden. Die erfindungsgemäße Vorgehensweise bewirkt, dass die Auslegung der Sensorelektrode sowie die Implementierung der Kapazitätsauswertung im Rahmen der, beispielsweise aus der eingangs genannten Regulierung sich ergebenden, Rahmenanforderungen flexibler wird. Dadurch, dass die frequenzabhängige Energiedichte breiter über die Frequenzskala verteilt ist und die Amplitudenmaxima geringer sind, können insgesamt höhere Frequenzen zur Auswertung verwendet werden. Dies geht unter anderem mit dem Vorteil einher, dass die Auswertegeschwindigkeit erhöht werden kann. Ein wesentlicher Vorteil der erfindungsgemäßen Lösung ist, dass die Variation der Ladepulsdauern durch entsprechende Ansteuerung, beispielsweise des Ladeschaltkreises oder allgemeiner eines entsprechenden Auswertungsschaltkreises, bewirkt werden kann. Die Implementierung des erfindungsgemäßen Verfahrens kann somit durch entsprechende Anpassung einer Steuerelektronik und dadurch optional mittels reiner Softwareanpassung umgesetzt werden. Entsprechend kann, sofern gewünscht, auch auf bereits existierender Hardware aufgebaut werden, wodurch sich wiederum Kostenvorteile ergeben.

Bevorzugt ist, dass ein Auswertungsvorgang mit einer Anzahl von Kopplungs- und Entkopplungszyklen durchgeführt wird, die zwischen 100 und 500, besonders bevorzugt zwischen 150 und 250 liegt.

Insbesondere ist gemäß einer vorteilhaften Weiterbildung vorgesehen, dass die erste Ladepulsdauer wie auch die zweite Ladepulsdauer zwischen 1,0 µs und 10,0 µs, bevorzugt zwischen 2,5 µs und 4,0 µs, dauern. Bei den daraus sich ergebenden Kopplungs- und Entkopplungsfrequenzen zwischen 250 kHz und 400 kHz werden in der Regel zuverlässige Ergebnisse in sehr kurzer Zeit erreicht.

Bevorzugt dauern alle Ladepulsdauern, also alle Kopplungs- und Entkopplungszyklen, des Auswertungsvorgangs zwischen 1,0 µs und 10,0 µs, bevorzugt zwischen 2,5 µs und 4,0 µs.

Gemäß einer ersten Alternative kann vorgesehen sein, dass die Pulsdauerabweichung Δt_{L,1} durch Veränderung der Entkopplungszeitdauer eingestellt wird, dass also die erste Ladepulsdauer t_{L,1} und die zweite Ladepulsdauer t_{L,2} sich nur in der Entkopplungszeitdauer unterscheiden, wobei die Kopplungszeitdauer beibehalten wird und für beide der ersten und zweiten Kopplungs- und Entkopplungszyklen gleich ist.

Bei einer anderen alternativen Vorgehensweise ist vorgesehen, dass die Veränderung der Ladepulsdauer zwischen erstem Kopplungs- und Entkopplungszyklus und zweitem Kopplungs- und Entkopplungszyklus durch Veränderung der Kopplungszeitdauer bei Beibehaltung der Entkopplungszeitdauer eingestellt wird.

Eine andere Alternative sieht eine Mischform aus den vorgenannten beiden Alternativen vor, dass nämlich die Pulsdauerabweichung Δt_{L,1} sowohl durch Veränderung der Kopplungszeitdauer als auch durch Veränderung der Entkopplungszeitdauer herbeigeführt wird.

Für die Variationen der Ladepulsdauern kann vorgesehen sein, dass innerhalb eines Auswertungsvorgangs mit einer Anzahl von N Kopplungs- und Entkopplungszyklen, die beispielsweise mit einem ganzzahligen Index i von 0 bis N-1 fortlaufend indiziert sein können, die Pulsdauerabweichung Δt_{L,i} zwischen zwei Ladepulsdauern t_{L,i+1} und t_{L,i} zweier aufeinanderfolgender Kopplungs- und Entkopplungszyklen mit den Indexzahlen i und i + 1 für wenigstens 50 % der Kopplungs- und Entkopplungszyklen eine relative Abweichung des Betrags der Ladepulsdauer | Δt_{L,i} | /t_{L,i} ≥ 0,1 aufweist. Mit anderen Worten soll vorgesehen sein, dass bei wenigstens 50 % der Kopplungs- und Entkopplungszyklen eine Pulsdauerabweichung gegenüber dem unmittelbar vorangehenden Kopplungs- und Entkopplungszyklus vorliegt und dass diese Pulsdauerabweichung die jeweils unmittelbar vorangehende Ladepulsdauer um wenigstens 10 % verändert. In bevorzugten Weiterbildungen liegt eine derartige Veränderung nicht nur bei 50 %, sondern bei wenigstens 80 %, in einer besonders bevorzugten Vorgehensweise sogar bei 100 % aller Kopplungs- und Entkopplungszyklen eines Auswertungsvorgangs vor.

Bei einer Weiterbildung des Verfahrens sind eine minimale Ladepulsdauer und eine maximale Ladepulsdauer sowie eine Anzahl von vorgegebenen Ladepulsdauerwerten vorgegeben. Zwei aufeinanderfolgende Kopplungs- und Entkopplungszyklen werden mit zwei unterschiedlichen der vorgegebenen Ladepulsdauerwerten angesteuert. Es ist also vorgesehen, dass die Ladepulsdauer nicht zufällig angesteuert wird oder eine Berechnung von Kopplungs- und/oder Entkopplungszeitdauern vorgenommen wird, sondern dass, beispielsweise auf einem das Verfahren steuernden Mikrocontroller, eine Liste mit wenigstens zwei Ladepulsdauerwerten, bevorzugt in Form von Paaren von Kopplungs- und Entkopplungszeitdauern, vorliegt, auf deren Grundlage die Veränderung der Ladepulsdauern gesteuert wird.

Insbesondere kann vorgesehen sein, dass die vorgegebenen Ladepulsdauerwerte äquidistant zwischen der minimalen Ladepulsdauer und der maximalen Ladepulsdauer verteilt sind. Beispielsweise kann vorgesehen sein, dass eine minimale Ladepulsdauer und eine maximale Ladepulsdauer vorgegeben sind, die beide zwischen 1,0 µs und 10 µs liegen, und dass zwischen der minimalen und maximalen Ladepulsdauer eine Anzahl von äquidistanten Ladepulsdauerwerten vorgesehen ist. Bevorzugt ist als minimale Ladepulsdauer 1,5 µs und als maximale Ladepulsdauer 5,0 µs vorgesehen, besonders bevorzugt als minimale Ladepulsdauer 2,0 µs und als maximale Ladepulsdauer 4,0 µs. Die Ladepulsdauern können unmittelbar vorgegeben sein oder durch die Kombination entsprechender Kopplungs- und Entkopplungszeitdauern.

Die Ladepulsdauern können in einer vorgegebenen Reihenfolge oder in einer zufälligen Reihenfolge zur Ansteuerung des Ladeschaltkreises genutzt werden.

Alternativ kann die Veränderung der Ladepulsdauer auch über das Vorgeben einer Maximalladefrequenz und einer Minimalladefrequenz erfolgen. Es kann eine Anzahl von vorgegebenen Ladepulsfrequenzen vorgesehen sein, wobei zwei aufeinanderfolgende Kopplungs- und Entkopplungszyklen mit zwei unterschiedlichen der vorgegebenen Ladepulsfrequenzen angesteuert werden. Insbesondere kann vorgesehen sein, dass die Ladepulsfrequenzen äquidistant zwischen der Maximalladefrequenz und der Minimalladefrequenz verteilt sind. Die Ladepulsfrequenzen können in einer vorgegebenen Reihenfolge oder in einer zufälligen Reihenfolge ausgewählt werden. Prinzipiell handelt es sich um dieselbe Vorgehensweise wie bei der unmittelbaren Auswahl von vorgegebenen Ladepulsdauern, je nach Implementierung kann die Betrachtung der zu den Ladepulsdauern reziproken Ladepulsfrequenzen eleganter umzusetzen sein. In Analogie zu den oben genannten vorgesehenen bevorzugten Ladepulsdauern kann vorgesehen sein, dass die Minimalladefrequenz und die Maximalladefrequenz zwischen 1000 kHz und 100 kHz, bevorzugt zwischen 667 kHz und 200 kHz, besonders bevorzugt zwischen 400 kHz und 250 kHz liegen.

Eine beispielhafte Verfahrensfolge zur Verwirklichung des erfindungsgemäßen Vorgehens umfasst, dass folgende Schritte durchgeführt werden:
- In dem Kopplungs- und Entkopplungszyklus wird die Sensorelektrode während der Kopplungszeitdauer t_{K} mit einer vorgegebenen Ladespannung des Ladeschaltkreises vollständig aufgeladen.
- Während der Entkopplungszeitdauer t_{E} wird die Sensorelektrode nach dem Entkoppeln der Sensorelektrode von dem Ladeschaltkreis mit einem Speicherschaltkreis gekoppelt. Der Speicherschaltkreis weist eine Speicherkapazität C_{L} auf. Infolge des Koppelns der Sensorelektrode mit dem Speicherschaltkreis erfolgt ein Umladen von in der Sensorelektrode gespeicherten Ladungsträgern zu der Speicherkapazität C_{L} hin.

In den mehreren Kopplungs- und Entkopplungszyklen wird die Sensorelektrode in jedem Kopplungszyklus während der Kopplungszeitdauer erneut vollständig aufgeladen. Mit der Ladung der geladenen Sensorelektrode wird die Speicherkapazität C_{L} während der hintereinanderfolgenden Entkopplungszeitdauern sukzessive, nicht notwendigerweise vollständig, mit Ladungsträgern belegt.

Das Auswerten des von dem Kapazitätswert der Sensorelektrode abhängigen Parameters umfasst, dass nach einer Anzahl von mehreren Kopplungs- und Entwicklungszyklen, bevorzugt einer vorgegebenen Anzahl von Kopplungs- und Entwicklungszyklen, eine an der Speicherkapazität anfallende Spannung erfasst wird und zur Ermittlung der Kapazität der Sensorelektrode herangezogen wird oder zur Ermittlung eines Werts herangezogen wird, der von der Kapazität der Sensorelektrode abhängig ist.

Die Auswertung beruht dabei insbesondere auf der dem Fachmann bekannten Abhängigkeit der Ladungsträgerumladung zwischen zwei Kondensatoren beziehungsweise Kapazitäten. Aufgrund dieses Zusammenhangs kann aus der Spannung über der Speicherkapazität nach einer Anzahl von Umladungsvorgängen zwischen der vollständig geladenen Sensorelektrode und der nicht beziehungsweise teilweise geladenen Speicherkapazität auf die Kapazität der Sensorelektrode oder auf eine von dieser abhängige Größe rückgeschlossen werden.

Die genaue Ausführung obliegt dem Fachmann. Sinnvollerweise ist C_{L} größer als die Kapazität der Sensorelektrode, wenn keine Annäherung eines Objekts vorliegt. Beispielsweise kann die Kapazität von C_{L} mindestens ein Vielfaches der Kapazität der Sensorelektrode betragen, bevorzugt mit einem Faktor der der vorgegebenen Anzahl von Kopplungs- und Entkopplungszyklen entspricht oder diese überschreitet. Bevorzugt ist C_{L} vor dem ersten Kopplungs- und Entkopplungszyklus vollständig entladen. Auch ist für die Kopplungs- und Entkopplungszeitdauern jeweils ein Wert zu wählen, der den Abschluss der gewünschten Umladung erlaubt. Dies ist bei den Größenordnungen der in dieser Anmeldung genannten Ladepulsdauern gegeben.

Für die Erfindung wesentlich ist, wie eingangs erläutert, die mehrfache Ladung der Sensorelektrode. Mögliche Abstrahlungseffekte, bei denen die Sensorelektrode in unerwünschtem Maße als Antenne fungiert, werden durch die erfindungsgemäße Abweichung der zweiten Ladepulsdauer von der ersten Ladepulsdauer vermieden oder in ihrer Auswirkung gedämpft.

Eine andere beispielhafte Verfahrensfolge zur Verwirklichung des erfindungsgemäßen Vorgehens umfasst:
- In dem Kopplungs- und Entkopplungszyklus wird die Sensorelektrode mit dem Speicherschaltkreis gekoppelt. Der Speicherschaltkreist weist eine Speicherkapazität C_{L} auf. Die Speicherkapazität C_{L} wird vor dem ersten Kopplungs- und Entkopplungszyklus, einmalig unter einer vorgegebenen Ladespannung aufgeladen. Mit dem Koppeln der Sensorelektrode mit dem Speicherschaltkreis wird ein Ladungsausgleich zwischen Speicherkapazität und Sensorelektrode herbeigeführt.
- Während der Entkopplungszeitdauer t_{E} wird die Sensorelektrode vollständig entladen, beispielsweise durch vorübergehendes Verbinden mit einem Massepotenzial.
- In den mehreren Kopplungs- und Entkopplungszyklen wird die Sensorelektrode in jedem Kopplungszyklus mit Ladung der Speicherkapazität aufgeladen. Dadurch wird die Speicherkapazität in den hinereinanderfolgenden Kopplungs- und Entkopplungszyklen und aufgrund der während jeder Entkopplungszeitdauer t_{E} erneut durchgeführten Entladung der Sensorelektrode, sequentiell, nicht notwendigerweise vollständig, entladen.

Das Auswerten des von dem Kapazitätswert der Sensorelektrode abhängigen Parameters umfasst, dass nach einer Anzahl von mehreren Kopplungs- und Entwicklungszyklen, bevorzugt einer vorgegebenen Anzahl von Kopplungs- und Entwicklungszyklen, eine an der Speicherkapazität anfallende Spannung erfasst wird und zur Ermittlung der Kapazität der Sensorelektrode herangezogen wird oder zur Ermittlung eines Werts herangezogen wird, der von der Kapazität der Sensorelektrode abhängig ist.

Die genaue Ausführung obliegt dem Fachmann. Sinnvollerweise ist C_{L} größer als die Kapazität der Sensorelektrode, wenn keine Annäherung eines Objekts vorliegt. Beispielsweise kann die Kapazität von C_{L} mindestens ein Vielfaches der Kapazität der Sensorelektrode betragen, bevorzugt mit einem Faktor der der vorgegebenen Anzahl von Kopplungs- und Entkopplungszyklen entspricht oder diese überschreitet. Auch ist für die Kopplungs- und Entkopplungszeitdauern jeweils ein Wert zu wählen, der für die Umladungsvorgänge erforderlich ist. Dies ist bei den Größenordnungen der in dieser Anmeldung genannten Ladepulsdauern gegeben. Wie schnell die Spannung über der Kapazität C_{L} infolge der wiederholten Entladung zu der Sensorelektrode hin abfällt, ist in dem Fachmann bekannter Relation unter anderem von der Kapazität der Sensorelektrode abhängig. Diese Abhängigkeit wird genutzt, um aus der über C_{L} gemessenen Spannung die Kapazität der Sensorelektrode oder einen von ihr abhängigen Wert, beispielsweise eine relative Änderung der Kapazität der Sensorelektrode abzuleiten.

Auch bei dieser Ausführungsmöglichkeit erfolgt eine wiederholte Ladung der Sensorelektrode, deren potentiell nachteiligen Auswirkungen durch die erfindungsgemäße Veränderung der Ladepulsdauer abgeschwächt werden.

Besonders bevorzugt ist die Verwendung eines der beschriebenen Verfahren zur Auswertung einer Kapazität oder Kapazitätsänderung eines eine Sensorelektrode aufweisenden Annäherungsschalters eines Kraftfahrzeugs.

Die nachfolgenden Abbildungen dienen der Illustration der vorstehend dargelegten Erfindung und ihrer Weiterbildungen. Es versteht sich, dass die vorstehend genannten wie auch nachfolgend erläuterten Merkmale nicht nur in der jeweils angegebenen Kombination, sondern auch in anderen Kombinationen oder in Alleinstellung verwendbar sind.

Es zeigen:
Fig. 1a: Eine schematische Darstellung eines beispielhaften aus der Praxis bekannten Ladevorgangs der Sensorelektrode;
Fig. 1b: eine schematische Darstellung einer Abstrahlcharakteristik der Sensorelektrode während des in Fig. 1a dargestellten Ladevorgangs;
Fig. 2a: eine schematische Darstellung eines Ladevorgangs der Sensorelektrode zur erfindungsgemäßen Auswertung des Kapazitätswerts einer Sensorelektrode;
Fig. 2b: eine schematische Darstellung einer Abstrahlcharakteristik der Sensorelektrode während des in Fig. 2a dargestellten Ladevorgangs;
Fig. 3: eine schematische Darstellung einer beispielhaften Ausgestaltung einer kapazitiven Annäherungssensoranordnung, bei welcher die erfindungsgemäße Verfahrensführung durchgeführt wird.

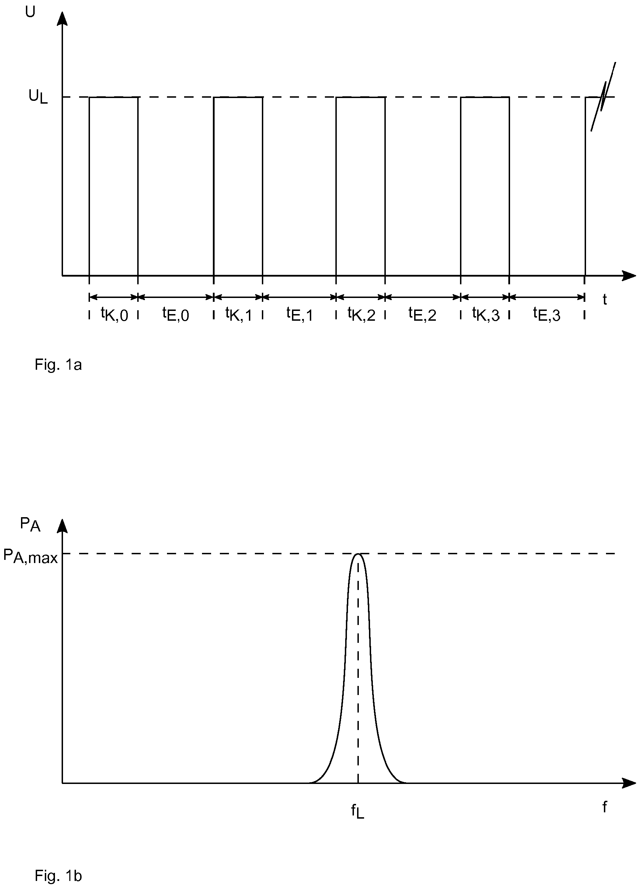

Fig. 1a ist eine Darstellung von Kopplungs- und Entkopplungszeitdauer während eines Abschnitts eines Ladevorgangs einer Sensorelektrode zum Zwecke der Auswertung ihrer Kapazität zu entnehmen. Es ist eine an der Sensorelektrode angelegte Spannung U in Abhängigkeit von der Zeit t dargestellt. Wie dargestellt, wird eine Ladespannung U_{L} für eine Kopplungszeitdauer t_{K,i} an der Sensorelektrode angelegt, woraufhin jeweils im Anschluss für eine Entkopplungszeitdauer t_{E,i} das Ladepotenzial von der Sensorelektrode getrennt wird. Die Vorgehensweise wird für eine Anzahl von Kopplungs- und Entkopplungszyklen wiederholt, wobei in Fig. 1a die Kopplungs- und Entkopplungszyklen 1 bis 4 dargestellt sind mit t_{K,i} und t_{E,i} für i = 0...3. Bei der Darstellung der Fig. 1a gilt, dass t_{K,1} = t_{K,2} = t_{K,3} = t_{K,4} = t_{K,i} für alle i = 0...N-1 der insgesamt N Kopplungs- und Entkopplungszyklen des Auswertungsvorgangs. Gleichermaßen gilt t_{E,1} = t_{E,2} = t_{E,3} = t_{E,4} = t_{E,i} für alle i = 0...N-1. Aus der gemäß Fig. 1a vorgenommenen Ansteuerung der Kopplung der Sensorelektrode mit dem Ladeschaltkreis resultiert eine Abstrahlcharakteristik der Sensorelektrode, die schematisch in Fig. 1b dargestellt ist. Fig. 1b zeigt eine Abstrahlleistung P_{A} in Abhängigkeit von einer Frequenz f, wobei der Maximalwert der Abstrahlcharakteristik erreicht wird bei der Ladepulsfrequenz f_{L}, die sich aus der Ladepulsdauer tᵢ = t_{L,1} = t_{K,1} + t_{E,1} = 1/f_{L} ergibt.

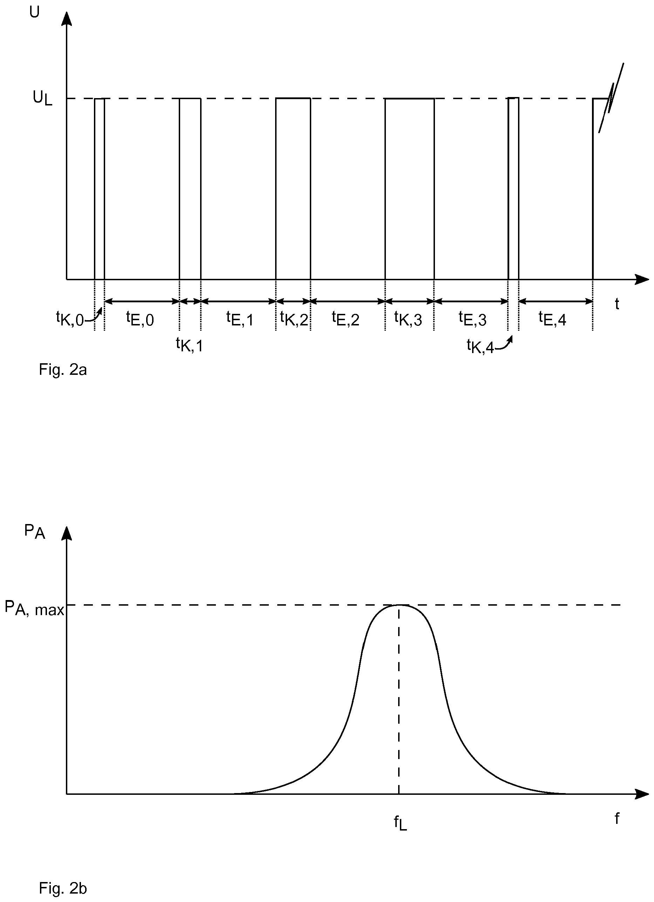

Das verbesserte Verfahren gemäß der Erfindung ist in einer beispielhaften Variante Fig. 2a zu entnehmen. Bei der Fig. 2a zu entnehmenden Umsetzung des Verfahrens ist die Entkopplungszeitdauer t_{E,i} für alle i = 0...N-1 unverändert; jedoch findet eine Veränderung der Ladepulsdauer statt, indem die Kopplungszeitdauer verändert wird. Insbesondere ist die Kopplungszeitdauer t_{K,0} ≠ t_{K,1} ≠ t_{K,2} ≠ t_{K,3}, wobei in der gezeigten Darstellung die Entkopplungszeitdauer mit 2,5 µs für alle Kopplungs- und Entkopplungszyklen konstant bleibt und die Kopplungszeitdauer ausgehend von t_{K,0} = 0,5 µs hin zu t_{K,3} = 2,0 µs in äquidistanten Schritten von 0,5 µs erhöht wird. In der gezeigten Ausgestaltung wird somit bei zwei aufeinander folgenden Kopplungs- und Entkopplungszyklen eine Pulsdauerabweichung von Δt_{L,0} = Δt_{L,1} = Δt_{L,2} = 0,5 µs vorgenommen, bevor nach Erreichen einer Kopplungszeitdauer von 2,0 µs in dem unmittelbar nachfolgenden Kopplungs- und Entkopplungszyklus wieder eine Kopplungszeitdauer von 0,5 µs vorgesehen ist, was in dem dargestellten Beispiel zu einem Betrag der Pulsdauerabweichung |Δt_{L,3}| = 1,5 µs führt. Die Veränderung der Ladepulsdauern erfolgt bei dem dargestellten Beispiel in einer vorgegebenen Reihenfolge, wobei die vorgegebene Reihenfolge die dargestellte und beschriebene sequentielle Erhöhung der Kopplungszeitdauer von einem Minimalwert zu einem Maximalwert und damit die sequentielle und kontinuierliche Erhöhung der Ladepulsdauer von der minimalen Ladepulsdauer zu der maximalen Ladepulsdauer vorsieht. Prinzipiell wäre aber gemäß den obigen Erläuterungen auch eine andere Reihung der Kopplungszeitdauern im Rahmen der Erfindung möglich.

Fig. 2b ist eine beispielhafte schematische Darstellung einer Abstrahlcharakteristik der Sensorelektrode während des in Fig. 2a dargestellten Ladevorgangs zu entnehmen. Insbesondere ist die maximale Abstrahlleistung P_{A, max} im Vergleich zu dem Maximalwert der in Fig. 1b dargestellten frequenzabhängigen Abstrahlleistung signifikant verringert, während die Halbwertsbreite der Funktion P_{A, max} bei der in Fig. 2b dargestellten Charakteristik gegenüber dem in Fig. 1b dargestellten funktionalen Zusammenhang deutlich verbreitert ist.

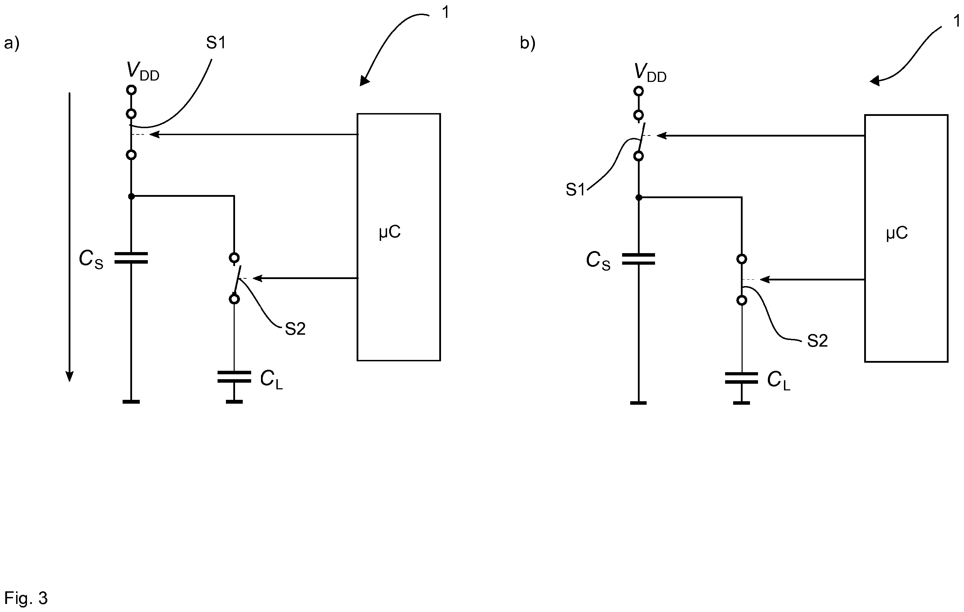

Fig. 3 ist eine schematische Darstellung einer beispielhaften Ausgestaltung einer kapazitiven Annäherungssensoranordnung zu entnehmen, bei welcher die erfindungsgemäße Verfahrensführung durchgeführt wird.

Die Annäherungssensoranordnung 1 weist eine Sensorelektrode auf, die durch die Kapazität C_{S} symbolisiert ist. Die Sensorelektrode ist in Fig. 3a) mit einem Ladeschaltkreis gekoppelt zur Spannungsversorgung mit V_{DD}. Andererseits ist eine Reihenschaltung von C_{S} mit einem Speicherschaltkreis möglich, der die Speicherkapazität C_{L} aufweist.

Die Schalter S₁ und S₂ sind über einen Mikrocontroller µC ansteuerbar. Zur Durchführung eines Umladungsvorgangs wird beispielsweise in einem ersten, in Fig. 1a dargestellten, Schritt die Sensorelektrode C_{S} mit dem Ladeschaltkreis gekoppelt zum Aufladen der Sensorelektrode unter der Ladespannung V_{DD}. Hiernach erfolgt ein Öffnen von S1 und ein Schließen von S₂ (in dieser Reihenfolge) zum elektrisch wirksamen Koppeln von C_{S} mit C_{L} zu einer Reihenschaltung von Kapazitäten. In der Folge erfolgt ein Ladungsträgerausgleich zwischen C_{S} und C_{L}. Diese Vorgehensweise wird sooft wiederholt, bis die vorgegebene Anzahl von Umladungsvorgängen n_{U,i} erreicht ist und die Speicherkapazität sukzessive aufgeladen ist bis zum gewünschten Arbeitspunkt. Damit ist ein Umladungszyklus beendet.

Selbstverständlich sind neben der gezeigten auch viele weitere Ausführungsformen möglich, in denen das erfindungsgemäße Verfahren in einer seiner Ausführungsformen durchführbar ist.

## Patentansprüche

1. Verfahren zum Auswerten eines Kapazitätswerts eines eine Sensorelektrode aufweisenden Annäherungsschalters eines Kraftfahrzeugs, wobei ein Auswertungsvorgang die Schritte aufweist:
- Durchführen eines Ladevorgangs der Sensorelektrode, wobei die Sensorelektrode in mehreren Kopplungs- und Entkopplungszyklen mit einem Ladeschaltkreis für eine Kopplungszeitdauer t_{K} gekoppelt und für eine Entkopplungszeitdauer t_{E} von dem Ladeschaltkreis entkoppelt wird,
wobei in einem Kopplungs- und Entkopplungszyklus während der Kopplungszeitdauer t_{K} ein wenigstens teilweises Laden der Sensorelektrode erfolgt, und
wobei während der Entkopplungszeitdauer t_{E} kein Laden der Sensorelektrode erfolgt,
- Auswerten eines von dem Kapazitätswert der Sensorelektrode abhängigen Parameters, wobei der Parameter eine an einem Ladung ansammelnden Kondensator gemessene Spannung oder eine Anzahl von Perioden des Ladens und/oder Entladens bis zum Überschreiten einer Schaltschwelle durch eine an der Sensorelektrode gemessene Spannung ist, wobei eine erste Ladepulsdauer t_{L,1}, die sich aus einer ersten Kopplungszeitdauer t_{K,1} und einer ersten Entkopplungszeitdauer t_{E,1} zusammensetzt mit t_{L,1} = t_{K,1} + t_{E,1}, eines ersten Kopplungs- und Entkopplungszyklus und eine zweite Ladepulsdauer t_{L,2}, die sich aus einer zweiten Kopplungszeitdauer t_{K,2} und einer zweiten Entkopplungszeitdauer t_{E,2} zusammensetzt mit t_{L,2} = t_{K,2} + t_{E,2}, eines unmittelbar auf den ersten Kopplungs- und Entkopplungszyklus folgenden zweiten Kopplungs- und Entkopplungszyklus voneinander in einer ersten Pulsdauerabweichung Δt_{L},₁ abweichen.

2. Verfahren nach Anspruch 1, **dadurch gekennzeichnet, dass** während eines Auswertungsvorgangs die Sensorelektrode einer Anzahl zwischen 100 und 500, bevorzugt zwischen 150 und 250, Kopplungs- und Entkopplungszyklen, unterzogen wird.

3. Verfahren nach einem der vorhergehenden Ansprüche, **dadurch gekennzeichnet, dass** die erste Ladepulsdauer und die zweite Ladepulsdauer zwischen 1,0 µs und 10,0 µs, bevorzugt zwischen 2,5 µs und 4,0 µs, dauern.

4. Verfahren nach einem der vorhergehenden Ansprüche, **dadurch gekennzeichnet, dass** die Pulsdauerabweichung Δt_{L,1} durch Veränderung der Entkopplungszeitdauer um den Wert t_{E,2}-t_{E,1} = Δt_{L,1} bei Beibehaltung der Kopplungszeitdauer mit t_{K,2} = t_{K,1} eingestellt wird.

5. Verfahren nach einem der Ansprüche 1 bis 3, **dadurch gekennzeichnet, dass** die Pulsdauerabweichung Δt_{L,1} durch Veränderung der Kopplungszeitdauer um den Wert t_{K,2} - t_{K,1} = Δt_{L,1} bei Beibehaltung der Entkopplungszeitdauer mit t_{E,2} = t_{E,1} eingestellt wird.

6. Verfahren nach einem der Ansprüche 1 bis 3, **dadurch gekennzeichnet, dass** die Pulsdauerabweichung Δt_{L,1} durch Veränderung der Kopplungszeitdauer und durch Veränderung der Entkopplungszeitdauer eingestellt wird, wobei die Pulsdauerabweichung Δt_{L,1} einen Wert von Δt_{L,1} = t_{K,2} - t_{K,1} + t_{E,2} - t_{E,1} aufweist.

7. Verfahren nach einem der vorhergehenden Ansprüche, **dadurch gekennzeichnet, dass** während eines Auswertungsvorgangs mit N Kopplungs- und Entkopplungszyklen die Ladepulsdauer t_{L,i} variiert wird mit der Maßgabe für Δt_{L,i} = t_{L,i+1} - t_{L,i}, dass | Δt_{L,i} | /t_{L,i} > 0,1 für wenigstens 50 %, bevorzugt wenigstens 80 %, besonders bevorzugt für 100 %, aller i = 0...N-1.

8. Verfahren nach einem der vorhergehenden Ansprüche, **dadurch gekennzeichnet, dass** eine minimale Ladepulsdauer und eine maximale Ladepulsdauer vorgegeben sind, wobei eine Anzahl von vorgegebenen Ladepulsdauerwerten vorgesehen ist, wobei zwei aufeinanderfolgende Kopplungs- und Entkopplungszyklen mit zwei unterschiedlichen der vorgegebenen Ladepulsdauerwerten angesteuert werden oder
dass eine Maximalladefrequenz und eine Minimalladefrequenz vorgegeben sind, wobei eine Anzahl von vorgegebenen Ladepulsfrequenzen vorgesehen ist, wobei zwei aufeinanderfolgende Kopplungs- und Entkopplungszyklen mit zwei unterschiedlichen der vorgegebenen Ladepulsfrequenzen angesteuert werden.

9. Verfahren nach Anspruch 8, **dadurch gekennzeichnet, dass** die vorgegebenen Ladepulsdauerwerte äquidistant zwischen der minimalen Ladepulsdauer und der maximalen Ladepulsdauer verteilt sind oder
dass die Ladepulsfrequenzen äquidistant zwischen der Maximalladefrequenz und der Minimalladefrequenz verteilt sind.

10. Verfahren nach Anspruch 8 oder nach Anspruch 9, **dadurch gekennzeichnet, dass**
- die Ladepulsdauern oder die Ladepulsfrequenzen in einer vorgegebenen Reihenfolge angesteuert werden oder
- die Ladepulsdauern oder die Ladepulsfrequenzen in einer zufälligen Reihenfolge angesteuert werden.

11. Verfahren nach einem der Ansprüche 8 bis 10, **dadurch gekennzeichnet, dass** die minimale Ladepulsdauer und die maximale Ladepulsdauer zwischen 1,0 µs und 10,0 µs, bevorzugt zwischen 1,5 µs und 5,0 µs, besonders bevorzugt zwischen 2,5 µs und 4,0 µs dauern oder dass
die Minimalladefrequenz und die Maximalladefrequenz zwischen 1000 kHz und 100 kHz, bevorzugt zwischen 667 kHz und 200 kHz, besonders bevorzugt zwischen 400 kHz und 250 kHz liegen.

12. Verfahren nach einem der vorhergehenden Ansprüche, **dadurch gekennzeichnet, dass**
in dem Kopplungs- und Entkopplungszyklus während der Kopplungszeitdauer t_{K} die Sensorelektrode mit einer vorgegebenen Ladespannung des Ladeschaltkreises mit Ladungsträgern vollständig aufgeladen wird,
wobei während der Entkopplungszeitdauer t_{E} nach dem Entkoppeln der Sensorelektrode von dem Ladeschaltkreis ein Koppeln der Sensorelektrode mit einem Speicherschaltkreis erfolgt, der eine Speicherkapazität C_{L} aufweist, zum Umladen von in der Sensorelektrode gespeicherten Ladungsträgern zu der Speicherkapazität C_{L} hin,
wobei in den mehreren Kopplungs- und Entkopplungszyklen die Sensorelektrode in jedem Kopplungszyklus während der Kopplungszeitdauer erneut vollständig aufgeladen wird und die Speicherkapazität C_{L} während der Entkopplungszeitdauer sukzessive, nicht notwendigerweise vollständig, mit Ladungsträgern geladen wird,
wobei das Auswerten des von dem Kapazitätswert der Sensorelektrode abhängigen Parameters umfasst, dass nach einer Anzahl von mehreren Kopplungs- und Entwicklungszyklen, bevorzugt einer vorgegebenen Anzahl von Kopplungs- und Entwicklungszyklen, eine an der Speicherkapazität anfallende Spannung erfasst wird und zur Ermittlung der Kapazität der Sensorelektrode herangezogen wird oder zur Ermittlung eines Werts herangezogen wird, der von der Kapazität der Sensorelektrode abhängig ist.

13. Verfahren nach einem der Ansprüche 1 bis 11, **dadurch gekennzeichnet, dass**
in dem Kopplungs- und Entkopplungszyklus während der Kopplungszeitdauer t_{K} ein Koppeln der Sensorelektrode mit einem Speicherschaltkreis erfolgt, der eine einmalig vor dem ersten Kopplungs- und Entkopplungszyklus unter einer vorgegebenen Ladespannung aufgeladene Speicherkapazität C_{L} aufweist, zum Ladungsausgleich zwischen Speicherkapazität und Sensorelektrode,
wobei während der Entkopplungszeitdauer t_{E} die Sensorelektrode vollständig entladen wird, beispielsweise durch vorübergehendes Verbinden mit einem Massepotenzial,
wobei in den mehreren Kopplungs- und Entkopplungszyklen die Sensorelektrode in jedem Kopplungszyklus mit Ladung der Speicherkapazität aufgeladen wird und dadurch die Speicherkapazität sequentiell, nicht notwendigerweise vollständig, entladen wird,
wobei das Auswerten des von dem Kapazitätswert der Sensorelektrode abhängigen Parameters umfasst, dass nach einer Anzahl von mehreren Kopplungs- und Entwicklungszyklen, bevorzugt einer vorgegebenen Anzahl von Kopplungs- und Entwicklungszyklen, eine an der Speicherkapazität anfallende Spannung erfasst wird und zur Ermittlung der Kapazität der Sensorelektrode herangezogen wird oder zur Ermittlung eines Werts herangezogen wird, der von der Kapazität der Sensorelektrode abhängig ist.

## Claims

1. Method for evaluating a capacitance value of a proximity switch of a motor vehicle having a sensor electrode, wherein an evaluation process comprises the steps of:
- Performing a charging process of the sensor electrode, wherein the sensor electrode is coupled to a charging circuit for a coupling time duration t_{K} and decoupled from the charging circuit for a decoupling time duration t_{E} in a plurality of coupling and decoupling cycles,
wherein in a coupling and decoupling cycle an at least partial charging of the sensor electrode takes place during the coupling time duration t_{K}, and
whereby no charging of the sensor electrode takes place during the decoupling time duration t_{E},
- Evaluating a parameter dependent on the capacitance value of the sensor electrode, the parameter being a voltage measured at a capacitor that accumulates charge or the parameter being a number of periods of charging and/or discharging until a switching threshold is exceeded by a voltage that is measured at the sensor electrode,
wherein
a first charging pulse duration t_{L,1,} which is composed of a first coupling time duration t_{K,1} and a first decoupling time duration t_{E,1}, with t_{L,1} = t_{K,1} + t_{E,1}, of a first coupling and decoupling cycle, and a second charging pulse duration t_{L,2}, which is composed of a second coupling time duration t_{K,2} and a second decoupling time duration t_{E,2,} with t_{L,2} = t_{K,2} + t_{E,2}, of a second coupling and decoupling cycle which is immediately following the first coupling and decoupling cycle, differ from one another in a first pulse duration deviation Δt_{L,1}.

2. Method according to claim 1, **characterized in that** during an evaluation process the sensor electrode is subjected to a number of between 100 and 500, preferably between 150 and 250, coupling and decoupling cycles.

3. Method according to any one of the preceding claims, **characterized in that** the first charging pulse duration and the second charging pulse duration last between 1.0 µs and 10.0 µs, preferably between 2.5 µs and 4.0 µs.

4. Method according to any one of the preceding claims, **characterized in that** the pulse duration deviation Δt_{L,1} is adjusted by changing the decoupling time duration by the value t_{E,2} - t_{E,1} = Δt_{L,1} while maintaining the coupling time duration with t_{K,2} = t_{K,1}.

5. Method according to any one of claims 1 to 3, **characterized in that** the pulse duration deviation Δt_{L,1} is adjusted by changing the coupling time duration by the value t_{K,2} - t_{K,1} = Δt_{L,1} while maintaining the decoupling time duration with t_{E,2} = t_{E,1}.

6. Method according to any one of claims 1 to 3, **characterized in that** the pulse duration deviation Δt_{L,1} is adjusted by changing the coupling time duration and by changing the decoupling time duration, wherein the pulse duration deviation Δt_{L,1} has a value of Δt_{L,1} = t_{K,2} - t_{K,1} + t_{E,2}-t_{E,1}.

7. Method according to any one of the preceding claims, **characterized in that** during an evaluation process with N coupling and decoupling cycles the charging pulse duration t_{L,i} is varied under the condition that at Δt_{L,i} = t_{L,i+1} - t_{L,i} it is | Δt_{L,i} | / t_{L,i} > 0.1 for at least 50%, preferably at least 80%, particularly preferably for 100%, of all i = 0...N-1.

8. Method according to any one of the preceding claims, **characterized**
**in that** a minimum charging pulse duration and a maximum charging pulse duration are predetermined, a number of predetermined charging pulse duration values being provided, two successive coupling and decoupling cycles being driven with two different ones of the predetermined charging pulse duration values, or
**in that** a maximum charging frequency and a minimum charging frequency are predetermined, a number of predetermined charging pulse frequencies being provided, two successive coupling and decoupling cycles being driven at two different ones of said predetermined charging pulse frequencies.

9. Method according to claim 8, **characterized in that** the predetermined charging pulse duration values are distributed equidistantly between the minimum charging pulse duration and the maximum charging pulse duration or
that the charging pulse frequencies are distributed equidistantly between the maximum charging frequency and the minimum charging frequency.

10. Method according to claim 8 or according to claim 9, **characterized in that**
- the charging pulse durations or the charging pulse frequencies are controlled in a predetermined sequence, or
- the charging pulse durations or the charging pulse frequencies are controlled in a random sequence.

11. Method according to any one of claims 8 to 10, **characterized in that** the minimum charging pulse duration and the maximum charging pulse duration last between 1.0 µs and 10.0 µs, preferably between 1.5 µs and 5.0 µs, particularly preferably between 2.5 µs and 4.0 µs, or **in that**
the minimum charging frequency and the maximum charging frequency are between 1000 kHz and 100 kHz, preferably between 667 kHz and 200 kHz, particularly preferably between 400 kHz and 250 kHz.

12. Method according to any one of the preceding claims, **characterized in that**
in the coupling and decoupling cycle, during the coupling time period t_{K}, the sensor electrode is fully charged with a predetermined charging voltage of the charging circuit with charge carriers,
wherein during the decoupling time period t_{E}, after the decoupling of the sensor electrode from the charging circuit, the sensor electrode is coupled to a storage circuit which has a storage capacitance C_{L,} for the purpose of recharging charge carriers stored in the sensor electrode to the storage capacitance C_{L,}
wherein in the plurality of coupling and decoupling cycles, the sensor electrode is fully charged again in each coupling cycle during the coupling time period, and the storage capacitance C_{L} is successively, but not necessarily fully, charged with charge carriers during the decoupling time period,
wherein evaluating the parameter dependent on the capacitance value of the sensor electrode comprises, after a number of coupling and development cycles, preferably a predetermined number of coupling and development cycles, detecting a voltage at the storage capacitance and using said voltage to determine the capacitance of the sensor electrode or using said voltage to determine a value dependent on the capacitance of the sensor electrode.

13. Method according to any one of claims 1 to 11, **characterized in that**
in the coupling and decoupling cycle, during the coupling time period t_{K}, the sensor electrode is coupled to a storage circuit which has a storage capacitance C_{L} charged once before the first coupling and decoupling cycle under a predetermined charging voltage, for charge equalization between the storage capacitance and the sensor electrode,
wherein during the decoupling time period t_{E} the sensor electrode is completely discharged, for example by temporarily connecting it to a ground potential,
wherein in the plurality of coupling and decoupling cycles, the sensor electrode is charged with charge carriers of the storage capacitance in each coupling cycle, thereby sequentially, but not necessarily completely, discharging the storage capacitance,
wherein evaluating the parameter dependent on the capacitance value of the sensor electrode comprises, after a number of multiple coupling and decoupling cycles, preferably a predetermined number of coupling and development cycles, detecting a voltage appearing at the storage capacitance and using it to determine the capacitance of the sensor electrode or using it to determine a value dependent on the capacitance of the sensor electrode.

## Revendications

1. Procédé d'évaluation d'une valeur de capacité d'un détecteur de proximité d'un véhicule automobile comportant une électrode de capteur, dans lequel un processus d'évaluation comporte les étapes suivantes :
- Effectuer un processus de charge de l'électrode de capteur, dans lequel l'électrode de capteur est couplée à un circuit de charge pendant une durée de couplage t_{K} et découplée du circuit de charge pendant une durée de découplage t_{E} en plusieurs cycles de couplage et de découplage,
dans lequel, dans un cycle de couplage et de découplage, une charge au moins partielle de l'électrode de capteur a lieu pendant la période de couplage t_{K}, et
de sorte qu'aucune charge de l'électrode de capteur n'a lieu pendant la période de découplage t_{E},
- Évaluer un paramètre dépendant de la valeur de la capacité de l'électrode de capteur, le paramètre étant une tension mesurée au niveau d'un condensateur accumulant une charge ou un nombre de périodes de charge et/ou de décharge jusqu'à ce qu'un seuil de commutation soit dépassé par une tension mesurée au niveau de l'électrode de capteur,
**caractérisé en ce que**
une première durée d'impulsion de charge t_{L,1,} qui est composée d'une première durée de couplage t_{K,1} et d'une première durée de découplage t_{E,1}, avec t_{L,1} = t_{K,1} + t_{E,1}, d'un premier cycle de couplage et de découplage et une seconde durée d'impulsion de charge t_{L,2,} qui est composée d'une seconde durée de couplage t_{K,2} et d'une seconde durée de découplage t_{E,2,} avec t_{L,2} = t_{K,2} + t_{E,2}, d'un second cycle de couplage et de découplage suivant immédiatement le premier cycle de couplage et de découplage diffèrent l'une de l'autre d'un premier écart de durée d'impulsion Δt_{L,1.}

2. Procédé selon la revendication 1, **caractérisé en ce que**, pendant un processus d'évaluation, l'électrode de capteur est soumise à un nombre de cycles de couplage et de découplage compris entre 100 et 500, de préférence entre 150 et 250.

3. Procédé selon l'une quelconque des revendications précédentes, **caractérisé en ce que** la première durée d'impulsion de charge et la deuxième durée d'impulsion de charge durent entre 1,0 µs et 10,0 µs, de préférence entre 2,5 µs et 4,0 µs.

4. Procédé selon l'une quelconque des revendications précédentes, **caractérisé en ce que** l'écart de durée d'impulsion Δt_{L,1} est ajusté en modifiant la durée de découplage de la valeur t_{E,2} - t_{E,1} = Δt_{L,1} tout en maintenant la durée de couplage avec t_{K,2} = t_{K,1}.

5. Procédé selon l'une quelconque des revendications 1 à 3, **caractérisé en ce que** l'écart de durée d'impulsion Δt_{L,1} est ajusté en modifiant la durée de couplage de la valeur t_{K,2} - t_{K,1} = Δt_{L,1} tout en maintenant la durée de découplage avec t_{E,2} = t_{E,1}.

6. Procédé selon l'une quelconque des revendications 1 à 3, **caractérisé en ce que** l'écart de durée d'impulsion Δt_{L,1} est ajusté en modifiant la durée de couplage et en modifiant la durée de découplage, l'écart de durée d'impulsion ΔtL_{,1} ayant une valeur de Δt_{L,1} = t_{K,2} - t_{K,1} + t_{E,2} - t_{E,1.}

7. Procédé selon l'une quelconque des revendications précédentes, **caractérisé en ce que**, pendant un processus d'évaluation avec N cycles de couplage et de découplage, on fait varier la durée de l'impulsion de charge t_{L,i}, à condition pour Δt_{L,i} = t_{L,i+1} - t_{L,i} que |Δt_{L,i} |/t_{L,i} > 0,1 pour au moins 50 %, de préférence au moins 80 %, de manière particulièrement préférée pour 100 %, de tous les i = 0...N-1.

8. Procédé selon l'une quelconque des revendications précédentes, **caractérisé**
**en ce qu'**une durée d'impulsion de charge minimale et une durée d'impulsion de charge maximale sont prédéterminées, un certain nombre de valeurs de durée d'impulsion de charge prédéterminées étant prévues, deux cycles de couplage et de découplage successifs étant entraînés avec deux valeurs différentes des valeurs de durée d'impulsion de charge prédéterminées ou
**en ce qu'**une fréquence de charge maximale et une fréquence de charge minimale sont prédéterminées, un certain nombre de fréquences d'impulsions de charge prédéterminées étant prévues, deux cycles de couplage et de découplage successifs étant entraînés à deux fréquences différentes desdites fréquences d'impulsions de charge prédéterminées.

9. Procédé selon la revendication 8, **caractérisé**
**en ce que** les valeurs de durée d'impulsion de charge prédéterminées sont réparties de manière équidistante entre la durée d'impulsion de charge minimale et la durée d'impulsion de charge maximale ou
**en ce que** les fréquences des impulsions de charge sont réparties de manière équidistante entre la fréquence de charge maximale et la fréquence de charge minimale.

10. Procédé selon la revendication 8 ou selon la revendication 9, **caractérisé en ce que**
- les durées des impulsions de charge ou les fréquences des impulsions de charge sont contrôlées dans une séquence prédéterminée, ou
- les durées des impulsions de charge ou les fréquences des impulsions de charge sont commandées dans un ordre aléatoire.

11. Procédé selon l'une quelconque des revendications 8 à 10, **caractérisé en ce que** la durée minimale de l'impulsion de charge et la durée maximale de l'impulsion de charge durent entre 1,0 µs et 10,0 µs, de préférence entre 1,5 µs et 5,0 µs, de manière particulièrement préférée entre 2,5 µs et 4,0 µs, ou
**en ce que** la fréquence de charge minimale et la fréquence de charge maximale sont comprises entre 1000 kHz et 100 kHz, de préférence entre 667 kHz et 200 kHz, de manière particulièrement préférée entre 400 kHz et 250 kHz.

12. Procédé selon l'une quelconque des revendications précédentes, **caractérisé en ce que**
dans le cycle de couplage et de découplage, pendant la période de couplage t_{K}, l'électrode de capteur est entièrement chargée avec une tension de charge prédéterminée du circuit de charge avec des porteurs de charge,
dans lequel pendant la période de découplage t_{E} après le découplage de l'électrode de capteur du circuit de charge, l'électrode de capteur est couplée à un circuit de stockage qui a une capacité de stockage C_{L} dans le but de recharger les porteurs de charge stockés dans l'électrode de capteur à la capacité de stockage C_{L},
dans lequel, dans la pluralité de cycles de couplage et de découplage, l'électrode de capteur est à nouveau complètement chargée dans chaque cycle de couplage pendant la période de couplage et la capacité de stockage C_{L} est successivement, pas nécessairement complètement, chargée avec des porteurs de charge pendant la période de découplage,
dans lequel l'évaluation du paramètre dépendant de la valeur de la capacité de l'électrode de capteur comprend, après un certain nombre de cycles de couplage et de développement, de préférence un nombre prédéterminé de cycles de couplage et de développement, la détection d'une tension apparaissant au niveau de la capacité de stockage et son utilisation pour déterminer la capacité de l'électrode de capteur ou son utilisation pour déterminer une valeur dépendant de la capacité de l'électrode de capteur.

13. procédé selon l'une quelconque des revendications 1 à 11, **caractérisé en ce que**
dans le cycle de couplage et de découplage, pendant la période de couplage t_{K}, l'électrode de capteur est couplée à un circuit de stockage qui a une capacité de stockage C_{L} chargée une fois avant le premier cycle de couplage et de découplage sous une tension de charge prédéterminée, pour une égalisation de charge entre la capacité de stockage et l'électrode de capteur,
dans lequel, pendant la période de découplage t_{E}, l'électrode de capteur est complètement déchargée, par exemple en la connectant temporairement à un potentiel de masse,
dans lequel, dans la pluralité de cycles de couplage et de découplage, l'électrode de capteur est chargée avec la charge de la capacité de stockage dans chaque cycle de couplage, déchargeant ainsi séquentiellement la capacité de stockage, pas nécessairement complètement,
dans lequel l'évaluation du paramètre dépendant de la valeur de la capacité de l'électrode de capteur comprend, après un certain nombre de cycles de couplage et de développement, de préférence un nombre prédéterminé de cycles de couplage et de découplage, la détection d'une tension apparaissant au niveau de la capacité de stockage et son utilisation pour déterminer la capacité de l'électrode de capteur ou son utilisation pour déterminer une valeur dépendant de la capacité de l'électrode de capteur.
